(19) Europäisches Patentamt
European Patent Office
Office européen des brevets

(11) EP 0 749 940 B1

(12) FASCICULE DE BREVET EUROPEEN

(45) Date de publication et mention de la délivrance du brevet: **11.08.1999 Bulletin 1999/32**

(51) Int. Cl.[6]: **C01B 21/072**, C30B 25/00

(21) Numéro de dépôt: **96401307.2**

(22) Date de dépôt: **17.06.1996**

# (54) Procédé de fabrication de trichites de nitrure d'aluminium

Verfahren zur Herstellung von Aluminiumnitridwhiskern

Process for the preparation of aluminium nitride whiskers

(84) Etats contractants désignés:
**DE GB IT NL SE**

(30) Priorité: **19.06.1995 FR 9507278**

(43) Date de publication de la demande:
**27.12.1996 Bulletin 1996/52**

(73) Titulaires:
- **AEROSPATIALE SOCIETE NATIONALE INDUSTRIELLE**
  **75016 Paris (FR)**
- **VIAM ALL Russian Institut of Aviation Materials**
  **107005 Moscou (RU)**

(72) Inventeurs:
- **Gribkov, Vladimir Nikolaevich**
  **125040 Moscou (RU)**
- **Shchetanov, Boris Vladimirovich**
  **129345 Moscou (RU)**
- **Umantsev, Eric Loguinovitch**
  **119501 Moscou (RU)**
- **Silaev, Vladimir Alexandrovich**
  **d. 1, kv. 66, 171260 Tverskaja Obl. (RU)**
- **Gorelov, Yurii Alexeevich**
  **d. 13, kv. 12, 171260 Tverskaja Obl. (RU)**
- **Lyasota, Piotr Phiodorovich**
  **d.12, kv. 69, 171260 Tverskaja Obl. (RU)**

(74) Mandataire: **Lhuillier, René et al**
**Cabinet Lepeudry,**
**52, avenue Daumesnil**
**75012 Paris (FR)**

(56) Documents cités:

| | |
|---|---|
| EP-A- 0 176 737 | EP-A- 0 284 222 |
| FR-A- 427 109 | US-A- 4 917 877 |
| US-A- 5 190 738 | US-A- 5 246 683 |

- **JOURNAL OF THE CERAMIC SOCIETY OF JAPAN, vol. 101, no. 4, Avril 1993, TOKYO(JP), pages 366-371, XP000389940 K. KOMEYA ET AL.: "Synthesis of AlN powder by carbothermal reduction-nitridation method."**

EP 0 749 940 B1

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

L'invention concerne un procédé de fabrication de trichites de nitrure d'aluminium qui peuvent être utilisées dans des composites métalliques ou polymères, des céramiques structurales, des matériaux isolants thermiques etc.

On entend ici par trichites ou whiskers des monocristaux filiformes pratiquement exempts de défauts qui ont en général un diamètre de 1 à 50 μm et une longueur pouvant aller de plusieurs μm à plusieurs cm.

Contrairement à d'autres composés céramiques, les trichites de nitrure d'aluminium présentent la combinaison la plus avantageuse d'une grande conductivité thermique et de propriétés diélectriques élevées. Elles présentent également des caractéristiques piézo-électriques beaucoup plus élevées que celles des quartz piézo-électriques classiques. Pour ces différentes raisons, les trichites de nitrure d'aluminium sont devenues très prometteuses pour la production de céramiques thermoconductrices et en particulier thermorésistantes, d'appareils de transmission fonctionnant sur la base de l'effet piézo-électrique etc.

Cependant, contrairement à ce qui est observé dans la production de trichites de carbure de silicium, les procédés de production de trichites de nitrure d'aluminium ne font pas l'objet de recherches approfondies et ne sont pas, jusqu'à présent, utilisés dans l'industrie.

On sait fabriquer ces trichites par différents types de procédés, à savoir :

- par dépôt en phase gazeuse en utilisant les réactions de nitruration de l'aluminium :

$$\underset{}{2\,Al} + \underset{(gaz)}{N_2} \rightarrow \underset{(solide)}{2AlN};$$

- par sublimation-condensation du nitrure d'aluminium dans un gradient de températures :

$$\underset{(solide)}{AlN} \xrightarrow{T_1} \underset{(solide)}{Al} + \underset{(gaz)}{N} \xrightarrow{T_2} \underset{(solide)}{AlN} \quad \text{avec } T_1 > T_2;$$

- par réduction de chlorures ou du bromures d'aluminium dans une atmosphère d'hydrogène et d'ammoniac :

$$AlCl_3 + NH_3 \longrightarrow \underset{(solide)}{AlN} + 3HCl; \text{ et}$$

- par réduction de l'alumine par le carbone, dans une atmosphère d'azote, selon la réaction :

$$Al_2O_3 + 3C + N_2 \rightarrow 2AlN + 3CO.$$

Lorsque l'on utilise l'une quelconque de ces réactions, il est nécessaire, pour que la condensation du nitrure d'aluminium se fasse sous la forme de trichites, que des éléments-solvants soient présents, sous forme d'impuretés, dans la zone de condensation. Ces solvants doivent assurer la mise en oeuvre du mécanisme VLS (vapeur-liquide-solide).

Il est connu d'utiliser en tant que solvants de ce type, par exemple les éléments suivants : silicium, molybdène, fer, nickel etc.

Lorsqu'on a besoin d'une petite quantité de trichites de nitrure d'aluminium, on utilise le procédé le plus facile, à savoir la nitruration de l'aluminium. Toutefois, dans ce procédé le produit est inévitablement contaminé par de l'aluminium libre et a inévitablement perdu les caractéristiques diélectriques requises. De plus, étant donné que le procédé nécessite des températures élevées (1600 à 2000°C), en règle générale, il est nécessaire d'employer des éléments chauffants et de l'outillage en graphite. Leur interaction avec l'aluminium conduit à la formation de carbure d'aluminium qui détruit les parties en graphite en raison de l'hydrolyse lors de leur contact avec l'humidité de l'air. C'est pourquoi un tel procédé n'est pas applicable dans la pratique industrielle.

Le procédé de sublimation-condensation du nitrure d'aluminium permet de produire des trichites de haute qualité, mais ce procédé n'est probablement pas mis en oeuvre à grande échelle en raison du prix élevé de la matière de départ et des grandes difficultés qu'il y a à réaliser un équipement permettant d'obtenir une grande productivité.

Par ailleurs, il est impossible de mettre la méthode au chlorure en oeuvre en atmosphère d'azote et la nécessité de la présence d'ammoniac suscite de nombreux problèmes avec les équipements industriels, du fait que des condensats solides de $NH_4Cl$ apparaissent sur les parois des chambres, des tubes et des accessoires. Au surplus, ce procédé est toxique.

C'est pourquoi le procédé le plus avantageux pour une production industrielle de trichites de nitrure d'aluminium est celui dans lequel la réaction suivante est utilisée :

$$Al_2O_3 + 3C + N_2 \rightarrow 2AlN + 3CO.$$

Les avantages de ce procédé sont :

1) les formes multiples, la simplicité et le prix bas des matières de départ;
2) l'absence de nécessité d'avoir un gradient de température dans la zone de réaction, c'est pourquoi il devient possible d'utiliser toute une série de fours industriels, y compris ceux ayant des dimensions hors-tout élevées;
3) la simplicité d'introduction des éléments activateurs dans la zone de réaction ensemble avec la charge;
4) une gamme suffisamment large de température (1600 - 2050°C) et de durée de réaction, ce qui permet de choisir le programme optimum pour la condensation du nitrure sous forme de trichites.

Toutefois, même ce procédé (tel que discuté ci-dessus) n'était pas jusqu'à présent suffisamment maîtrisé pour être utilisé dans la production industrielle.

Contrairement au carbure de silicium, le nitrure d'aluminium présente la caractéristique avantageuse d'avoir de nombreuses formes différentes de croissance. Parmi les orientations cristallographiques connues, à savoir $\langle 0001 \rangle$, $\langle 10\bar{1}0 \rangle$, $\langle 1201 \rangle$, $\langle 10\bar{1}1 \rangle$ et $\langle 2\bar{4}23 \rangle$, les trichites avec la seule orientation $\langle 0001 \rangle$ présentent une forme acceptable de section transversale (hexagonale ou proche du cercle) pour l'utilisation dans des composites et présentent une résistance suffisamment élevée pouvant atteindre environ 7000 à 8000 MPa (700 à 800 kgf/mm$^2$). De telles trichites ont également un effet piézoélectrique maximum.

Par conséquent, le procédé applicable en pratique pour réaliser les trichites de nitrure d'aluminium doit assurer une croissance préférentielle des trichites avec exactement une telle orientation cristallographique.

La présente invention a donc pour but de mettre au point un procédé industriel de fabrication de trichites de nitrure d'aluminium, lequel procédé assure

- la possibilité d'utiliser des équipements suffisamment simples et fiables pour faire croître lesdites trichites;
- la production de trichites ayant une résistance d'au moins environ 5000 à 7000 MPa (500 à 700 kgf/mm$^2$);
- l'obtention de la productivité la plus élevée et d'un bon rendement économique grâce à l'utilisation de matériaux de départ bon marché.

Ces buts sont atteints selon l'invention qui fournit un procédé pour produire des trichites de nitrure d'aluminium par réduction de l'alumine par le carbone en atmosphère d'azote, à une température de 1800 à 2000°C. Ce procédé est mis en oeuvre dans un four horizontal à fonctionnement semi-continu, muni d'un dispositif de chauffage en graphite. On fait avancer périodiquement dans le four des conteneurs en graphite dont la charge est constituée d'un mélange pulvérulent d'alumine, de carbone et d'un catalyseur de croissance [contenant le ou les élément(s)-solvant(s)] pour la mise en oeuvre selon le mécanisme VLS défini ci-dessus.

Selon l'invention, on utilise, en tant que catalyseur de croissance, de la poudre de fer-carbonyle.

Plus précisément, l'invention a pour objet un procédé pour produire des trichites de nitrure d'aluminium par réduction de l'alumine par le carbone en atmosphère d'azote, à une température de 1800 à 2000°C, en présence d'un catalyseur de croissance contenant un élément-solvant, caractérisé en ce qu'il comprend essentiellement l'étape consistant à faire avancer périodiquement, à travers la zone de travail d'un four horizontal muni d'un dispositif de chauffage en graphite, à contre-courant d'un flux d'azote, un conteneur en graphite muni d'un mélange d'alumine, de carbone et de fer-carbonyle, en tant que catalyseur de croissance, présent en une quantité capable d'assurer la mise en oeuvre du mécanisme VLS et en ce que le temps de passage du conteneur dans la zone de travail est dans la gamme de 20

à 120 minutes.

Avantageusement, le fer-carbonyle est utilisé en une proportion de 0,1 à 5,0% en poids du mélange car dans cette gamme de concentrations, on observe une croissance stable de trichites de nitrure d'aluminium selon le processus VLS. Ces trichites sont de grande qualité et se forment avec un rendement maximum. Si la proportion de fer-carbonyle diminue jusqu'à moins de 0,1% en poids, on observe une diminution du rendement et de la productivité du procédé, respectivement. Une augmentation de la proportion de fer-carbonyle au-delà de 5,0% en poids conduit à la croissance de trichites présentant des défauts et contaminées par le fer.

Avantageusement, la teneur en carbone dans la charge est de 5 à 25% en poids. Au-dessous de 5% en poids, la productivité diminue et au-dessus de 25% en poids il se forme des trichites présentant de grands défauts en raison d'une forte intensification du procédé et d'une sursaturation.

Les conteneurs en graphite munis de la charge et sur la surface desquels croissent les trichites se déplacent à travers le four, à contre-courant du flux d'azote. Dans le cas contraire, lorsque les conteneurs se déplacent à travers des zones plus froides dans le four, il apparaît sur les trichites qui se sont déjà développées une croissance secondaire de branches latérales et les trichites sont contaminées par du condensat.

La durée de croissance optimum qui correspond au temps de passage du conteneur dans la zone de travail et se situe dans la gamme de 20 à 120 minutes, dépend de la température de réaction. Plus précisément, plus la température est élevée, moins la durée de traversée par le conteneur de la zone de travail dans le four doit être longue, afin d'éviter l'épaississement secondaire des trichites selon le mécanisme VS (vapeur-solide) et l'augmentation de leurs défauts. La durée de traversée de la zone de travail est définie par la vitesse ou la fréquence des passages forcés des conteneurs.

Le processus de croissance des trichites est toujours mis en oeuvre dans la gamme de 1800 à 2000°C car ces températures permettent la croissance de trichites fines et les plus résistantes. Il convient à ce propos de noter qu'une augmentation de température jusqu'à 1950°C augmente la productivité d'un ordre de grandeur mais conduit à une augmentation du diamètre des trichites et à une diminution de leur résistance mécanique.

Le procédé défini ci-dessus a été testé et mis au point en utilisant des fours industriels fonctionnant en semi-continu.

Selon ce procédé, on a obtenu des trichites de nitrure d'aluminium présentant un diamètre de 1 à 3 μm, une orientation de croissance préférentielle (supérieure à 95%) de ⟨1001⟩ et une résistance mécanique pouvant atteindre environ 8000 MPa (800 $kgf/mm^2$). Ce procédé s'est révélé avoir une productivité acceptable pour son utilisation industrielle.

Les exemples qui suivent sont destinés à illustrer et mieux expliquer l'invention.

<u>Exemple 1</u> :

Pour produire des trichites de nitrure d'aluminium, on a utilisé un four semi-continu à dispositif de chauffage en graphite, ayant un diamètre intérieur de 125 mm, une longueur totale de 1500 mm et une longueur de zone de température maximale uniforme (zone de travail) d'environ 400 mm. Deux nacelles en graphite de 200 mm de long chacune, disposées l'une sur l'autre, ont été utilisées comme conteneurs. La charge contenant 89% en poids d'alumine, 10% en poids de carbone et 1% en poids de fer-carbonyle ayant une granulométrie de 1 à 3 μm, a été placée dans chacune des nacelles en une couche d'environ 10 mm d'épaisseur. La température dans la zone de travail a été maintenue égale à 1850°C. Le four a été purgé avec de l'azote dont le débit était égal à $1m^3/h$.

On a fait passer les conteneurs à contre-courant du flux d'azote, leur vitesse étant telle que leur durée de séjour dans la zone de travail soit égale à 45 minutes. En 24 heures, on a ainsi obtenu environ 150 g de trichites de nitrure d'aluminium ayant un diamètre de 1 à 3 μm. Ces trichites présentaient l'orientation de croissance cristallographique préférentielle de ⟨0001⟩ et une résistance mécanique d'environ 7000 MPa (700 $kgf/mm^2$), ne contenaient pratiquement pas d'aluminium libre en tant qu'impureté et présentaient des propriétés diélectriques élevées.

<u>Exemple 2</u> :

Des trichites de nitrure d'aluminium ont été formées d'une manière similaire de celle décrite dans l'exemple 1, mais la température dans la zone de travail était égale à 1950°C et le conteneur y restait pendant 25 minutes. En 24 heures, on a ainsi obtenu environ 1 kg de trichites présentant un diamètre d'environ 10 μm et une résistance mécanique de 5000 MPa (500 $kgf/mm^2$).

<u>Exemple 3</u> :

La croissance des trichites s'est faite d'une manière similaire de celle décrite dans l'exemple 1 mais avec une quantité de fer-carbonyle égale à 0,3% en poids et une proportion de carbone de 5% en poids. Les trichites résultantes

n'étaient pas différentes de celles obtenues selon l'exemple 1 mais dans cet exemple la productivité a diminué pour n'être plus que de 100 g/jour.

Exemple 4 :

Le processus était similaire de celui décrit dans l'exemple 1 mais la teneur en fer-carbonyle de la charge était égale à 3% en poids et la teneur en carbone était de 20% en poids. La productivité résultante du procédé était de 150 g/jour et la résistance mécanique des trichites d'environ 6000 MPa (600 kgf/$mm^2$).

## Revendications

1. Procédé pour produire des trichites de nitrure d'aluminium par réduction de l'alumine par le carbone en atmosphère d'azote, à une température de 1800 à 2000°C, en présence d'un catalyseur de croissance contenant un élément-solvant, caractérisé en ce qu'il comprend essentiellement l'étape consistant à faire avancer périodiquement, à travers la zone de travail d'un four horizontal muni d'un dispositif de chauffage en graphite, à contre-courant d'un flux d'azote, un conteneur en graphite muni d'un mélange d'alumine, de carbone et de fer-carbonyle, en tant que catalyseur de croissance, présent en une quantité capable d'assurer la mise en oeuvre du mécanisme VLS et en ce que le temps de passage du conteneur dans la zone de travail est dans la gamme de 20 à 120 minutes.

2. Procédé selon la revendication 1, caractérisé en ce que le fer-carbonyle est utilisé en une proportion de 0,1 à 5,0% en poids du mélange.

3. Procédé selon la revendication 1 ou 2, caractérisé en ce que la teneur en carbone dans la charge est de 5 à 25% en poids.

## Claims

1. A process for producing aluminium nitride whiskers by reducing alumina with carbon in a nitrogen atmosphere, at a temperature of 1800 to 2000°C, in the presence of a growth activator containing a solvent element, characterized in that it essentially comprises the step of periodically feeding, through the working area of a horizontal furnace equipped with a graphite heating device, counter to a flow of nitrogen, a graphite container charged with a mixture of alumina, carbon and carbonyl iron, as a growth activator, which is present in an amount capable of implementing the VLS mechanism, and in that the time taken by the container to pass through the working zone is in the range of 20 to 120 minutes.

2. The process according to claim 1, characterized in that carbonyl iron is used in a proportion representing 0.1 to 5.0 weight % of the mixture.

3. The process according to claim 1 or 2, characterized in that the carbon content of the charge is of 5 to 25 weight %.

## Patentansprüche

1. Verfahren zur Herstellung von Aluminiumnitridwhiskern mittels Reduktion von Aluminiumoxid mit Kohlenstoff unter Stickstoffatmosphäre bei einer Temperatur von 1800 bis 2000°C in Gegenwart eines Wachstumskatalysators, der ein als Flußmittel dienendes Element enthält, dadurch gekennzeichnet, daß es im wesentlichen den Schritt umfaßt, daß ein mit einer Mischung aus Aluminiumoxid, Kohlenstoff und Eisencarbonyl als Wachstumskatalysator beaufschlagter Behälter aus Graphit periodisch in Gegenstromrichtung zu einem Stickstoffstrom durch einen Arbeitsbereich eines mit einer Heizvorrichtung aus Graphit versehenen Horizontalofens bewegt wird, wobei der Wachstumskatalysator in einer zur Durchführung einer Reaktion nach dem Gas-Flüssigkeit-Festkörper-Mechanismus ausreichenden Menge vorliegt, und dadurch, daß die Zeit für den Durchgang des Behälters durch den Arbeitsbereich zwischen 20 und 120 Minuten dauert.

2. Verfahren nach Anspruch 1, dadurch gekennzeichnet, daß das Eisencarbonyl in einem Anteil von 0,1 bis 5,0 Gew.-% von der Mischung eingesetzt wird.

3. Verfahren nach Anspruch 1 oder 2, dadurch gekennzeichnet, daß der Gehalt an Kohlenstoff in der Charge 5 bis 25 Gew.-% beträgt.